# EUROPEAN PATENT APPLICATION

(11) **EP 1 209 783 A2**
(43) Date of publication of application: **29.05.2002**
(21) Application number: 01309303.4
(22) Date of filing: 01.11.2001
(51) Int. Cl.: H01S 5/14, H01S 5/30

(54) **Semiconductive laser module, laser unit, and raman amplifier**

(30) Priority: 02.11.2000 JP 2000336321
(71) Applicant: THE FURUKAWA ELECTRIC CO., LTD., Tokyo (JP)
(72) Inventor: Matsuura, Hiroshi, The Furukawa Electric Co. Ltd., Tokyo (JP); Mimura, Yu, The Furukawa Electric Co. Ltd., Tokyo (JP); Aikiyo, Takeshi, The Furukawa Electric Co. Ltd., Tokyo (JP); Shimizu, Takeo, The Furukawa Electric Co. Ltd., Tokyo (JP)
(74) Representative: Freed, Arthur Woolf

(57) **Abstract**

A semiconductive laser module according to the present invention is configured with a semiconductive laser module having a semiconductive laser device, a cavity formed with at least one light feedback means included, and an optical fiber located at a front side of the cavity, wherein an optical filter for transmitting light of wavelength within a predetermined range is disposed in the cavity. The above-noted semiconductive laser module additionally has a combination of a collimator and a focusing lens for coupling emitted light from the semiconductive laser device with the optical fiber, and the optical filter is disposed between the collimator and the focusing lens. The optical filter has a dielectric multilayered filter for transmitting a desired wavelength. A laser unit according to the present invention is configured with a plurality of semiconductive laser modules as noted above, and a polarization combiner for making a polarization combination of emitted light from the plurality of semiconductive laser modules. A Raman amplifier according to the present invention has a pumping light source configured with the semiconductive laser module or the laser unit.

## Description

### Technical Field

The present invention relates to a Raman amplifier for use in optical communication, and a semiconductive laser module and a laser unit for use as a pumping light source for the Raman amplifier.

### Background

In most applications to the optical fiber communication system at present, there is employed a rare earth doped fiber amplifier. In particular, an Erbium doped optical fiber amplifier (hereinafter referred to as "EDFA") having doped Erbium is frequently used. However, the EDFA has a practical gain wavelength bandwidth ranging simply from 1530 nm to 1610 nm. Further, the EDFA has a wavelength dependency in the gain to give rise to a difference in gain depending on the wavelength of signal light, in application to wavelength division multiplexed light.

In advancement of the DWDM (dense wavelength division multiplexing), the Raman amplification has gathered an increased expectancy as an amplification system with a wider band than the EDFA. The Raman amplification is an optical signal amplification method using the following phenomenon. When strong light (pumping light) is input to an optical fiber, the gain has a peak shifted by an induced Raman scattering from the pumping light's wavelength, toward the longer wavelength side, at approx. 100 nm or near therefrom (a frequency lower by approx. 13 THz on assumption of the use of pumping light in a 1400 nm band). If signal light of a wavelength bandwidth in which the above-noted gain is obtainable is input to the optical fiber thus pumped, then the signal light is amplified.

Although the Raman amplification has such a feature that the wavelength for gain to be generated can be arbitrarily changed by varying the wavelength of pumping light, the gain (Raman gain) is small. Further, because the gain to be used is shifted from the pumping light's wavelength by a predetermined wavelength (Raman shift) toward the longer wavelength side, the variation in wavelength of pumping light provides a variation in the wavelength for the gain to be generated, causing the amplification characteristic of signal light to be varied. Therefore, as the pumping light source to be used for Raman amplification, there is employed a high-output semiconductive laser module having a wavelength stabilized by a fiber grating.

The EDFA has a practical gain wavelength bandwidth from 1530 nm to 1610 nm or near, but the Raman amplification is almost free from restriction to the wavelength bandwidth (while practically a range of 1300 nm to 1650 nm is considered to be used, and the wavelength bandwidth of pumping light ranges from 1200 nm to 1550 nm). In other words, if the wavelength of pumping light to be input to an optical fiber is changed, the gain to appear is shifted from the pumping light's wavelength by a predetermined wavelength toward the longer wavelength side, to allow the amplification gain to be obtained at an arbitrary wavelength. Therefore, in the WDM (wavelength division multiplexing), the number of channels of signal light can be yet increased.

Because glass molecules constituting the optical fiber have various vibrating configurations, the above-noted gain becomes a distribution gain having a wavelength distribution, for example, as a distribution with a width of 20 nm or near. In order for the wavelength dependency of gain to be flat over a wide wavelength bandwidth, a variety of wavelengths of pumping light are multiplexed to properly adjust wavelengths of respective pumping lasers, outputs of the same and the like. In the Raman amplification, an existing optical fiber for communication can be used as an amplification medium. The Raman gain in use thereof is as small as approx. 3dB for a pumping light input of 100 mW. It therefore is necessary to obtain strong pumping light by multiplexing. It is common to multiplex pumping light to a range from 500 mW to 1 W or near in total.

### SUMMARY OF THE INVENTION

According to the present invention, a semiconductive laser module, a laser unit, and a Raman amplifier are configured as follows:

A first semiconductive laser module according to the present invention comprises a semiconductive laser module having a semiconductive laser device, a cavity formed with at least one light feedback means included, and an optical fiber located at a front side of the cavity, wherein an optical filter for transmitting light of wavelength within a predetermined range is disposed in the cavity.

In a second semiconductive laser module according to the present invention, the above-noted semiconductive laser module additionally has a collimator and a focusing lens for coupling light emitted from the semiconductive laser device with the optical fiber, and the optical filter is disposed between the collimator and the focusing lens.

A laser unit according to the present invention comprises a plurality of first or second semiconductive laser modules, and a polarization beam combiner for polarization-combining the light emitted from the plurality of semiconductive laser modules.

A Raman amplifier according to the present invention has a pumping light source comprising one of the first or second semiconductive laser module and the laser unit.

### BRIEF DESCRIPTION OF THE ACCOMPANYING DRAWINGS

Fig. 1 is an illustration for explanation of a first embodiment of semiconductive laser module according to the present invention;
Fig. 2 is an illustration for explanation of a second embodiment of semiconductive laser module according to the present invention;
Fig. 3 is an illustration for explanation of a third embodiment of semiconductive laser module according to the present invention;
Fig. 4 is an illustration for explanation of a fourth embodiment of semiconductive laser module according to the present invention;
Fig. 5 is an illustration for explanation of a fifth embodiment of semiconductive laser module according to the present invention;
Fig. 6 is an illustration for explanation of a sixth embodiment of semiconductive laser module according to the present invention;
Fig. 7 is an illustration for explanation of a seventh embodiment of semiconductive laser module according to the present invention;
Fig. 8 is an illustration for explanation of an eighth embodiment of semiconductive laser module according to the present invention;
Fig. 9 is an illustration for explanation of a first embodiment of Raman amplifier according to the present invention;
Fig. 10 is an illustration for explanation of a second embodiment of Raman amplifier according to the present invention;
Fig. 11A is a graph showing an example of transmittance spectrum (ordinate = transmittance percentage, abscissa = wavelength of pumping light), 2 nm in half-value full-width, of an optical filter film in an embodiment of the present invention;
Fig. 11B is a graph showing an example of transmittance spectrum (ordinate = transmittance percentage, abscissa = wavelength of pumping light), 3 nm in half-value full-width, of an optical filter film in an embodiment of the present invention;

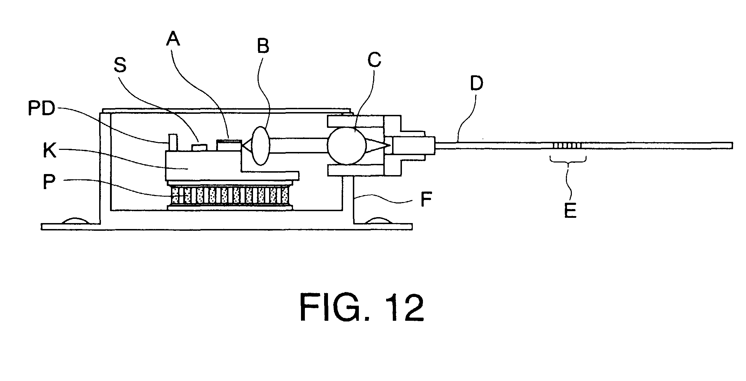

Fig. 12 is an illustration for explanation of a conventional semiconductive laser module; and

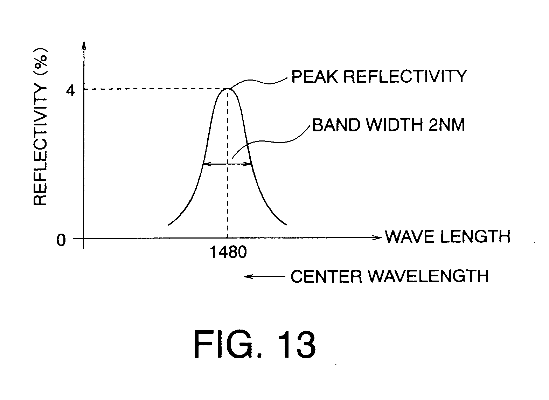

Fig. 13 is a graph showing an example of spectrum (ordinate = transmittance percentage, abscissa = wavelength of pumping light) of output light from the semiconductive laser module of Fig. 12.

### DETAILED DESCRIPTION

The laser module with fiber grating, having been used as an pumping light source for Raman amplifier has the following problems:
(1) As in the Raman amplification, a process of the amplification to occur is very short, if the pump light strength fluctuates, the Raman gain also is fluctuated, which appears as a fluctuation in strength of signal light. Further, because noises of pumping light constitute as they are noises of signal light, it is desirable for pumping light to be small of noise.
(2) If the lasing spectrum of the laser beam outputted from a semiconductive laser module with fiber grating is narrow, the SBS (stimulated Brilloun scattering) due to lattice vibrations of glass molecules constituting the optical fiber remarkably occurs to be a cause for noises.
(3) The Raman amplification to be small of Raman gain needs the pumping light source to have a very high output in terms not simply of an entire optical output in a multiplexed state of a plurality of pumping modules, but also of an optical output of a respective single pumping module.
(4) In the Raman amplification, the pumping system falls within three kinds: a forward pumping, a backward pumping, and a bi-directional pumping. In the Raman amplification at present, the backward pumping is major. This is because the forward pumping has a non-linearity problem, and the problem of the fluctuation of pumping light strength becomes by far significant in the forward pumping system in which a weak signal advances together with strong pumping light in the same direction. It therefore is desirable to provide a stable pumping light source applicable to the forward pumping, as well.
(5) In the Raman amplification, the amplification of signal light occurs in the case where the signal light and pumping light coincide with each other in polarization direction, the polarization dependency of amplification gain constitutes a material problem. In other words, it is material to decrease the influence of deviation between the polarization direction of signal light and the polarization direction of pumping light. It therefore is necessary to depolarize a laser beam emitted from semiconductive laser device as substantially complete linearly polarized light. In the backward pumping in which the polarization of signal light is made random during transmission, there occurs no practical problem, but in the forward pumping in which the polarization dependency is strong, there is a desideratum for the DOP (degree of polarization) to be made small, such as by use of polarization combination of the pumping light and polarization maintaining fiber (PMF). However, for example, in the depolarization in which the lasing spectrum of the semiconductive laser module with fiber grating is narrow in line width, the laser beam has a long coherent length, so that the PMF (depolarizer) connected for the depolarization has a very great length.

Studies by the present inventors show that it is required for a pumping light source of a Raman amplifier to have such characteristics (1) to (7) as following. According to the present invention, a semiconductive laser module, a laser unit, and a Raman amplifier are adapted to meet the following required characteristics (1) to (7).
(1) Noise of pumping light to be small:
   The RIN (relative intensity noise) should have a very low value within a predetermined frequency range. As an example, it is desirable for the RIN to be -130 dB/Hz or less within a frequency range of 0 to 2 GHz.
(2) DOP (degree of polarization) of pumping light to be small:
   It is necessary for the coherent length to be short, that is, to have a depolarizing tendency in a multi-mode, or to be free of depolarization due to depolarization combination. For the multi-mode, it is sufficient for longitudinal modes to be at least three, preferably four to five or more, within a lasing spectrum width (the width at a wavelength reduced by 3 dB from a peak of the spectrum).
(3) Optical output of pumping light to be high:
   It is necessary for the semiconductive laser module to have an optical output 50 mW or more, preferably 100 mW or more, more preferably 300 mW or more, yet more preferably 400 mW or more.
(4) Wavelength stability of pumping light to be good:
   In consideration of variations in lasing wavelength that cause a variation to the gain wavelength bandwidth, there is necessitated a wavelength stabilization technique such as by a DFB laser (distributed feedback laser) or DBR laser (distributed Bragg reflector laser). It is preferable for the variation width to be, for example, within ± 1 nm under whole driving conditions (ambient temperature: 0 to 75°C, driving current: 0 to 1 A).
(5) Lasing spectrum width of pumping light to be narrow to some degree:
   If the lasing spectrum width of a respective pumping laser module is too wide, a wavelength combining coupler has an increased wave combining loss and an increased number of longitudinal modes contained in the spectrum width, so that the longitudinal modes work during lasing, causing noises and gain variations. It therefore is preferable for the lasing spectrum width to be 2 nm or less, or 3 nm or less. On the other hand, if it is too narrow, there appears a kink in current vs. optical output characteristic, constituting a hindrance to the control in laser drive.
(6) SBS not to occur:
   If the narrow wavelength bandwidth is subject to concentration of high optical outputs, such as by a fiber grating, there occurs an SBS with an increase in noise. From this point of view, the pumping light needs to be a so-called multi-mode in which a plurality of longitudinal modes exist within a lasing spectrum width, providing that the optical output (light intensity) in respective longitudinal mode is kept from exceeding an SBS occurrence threshold value.
(7) Incorporation of an optical isolator to be preferable:
   In order for the laser not to be unstable in operation due to reflected return light, it is preferable that an optical isolator is incorporated.
   According to the present invention, there are provided a semiconductive laser module, a laser unit, and a Raman amplifier suitably adapted to meet the foregoing necessary characteristics (1) to (7).

### First embodiment of semiconductive laser module

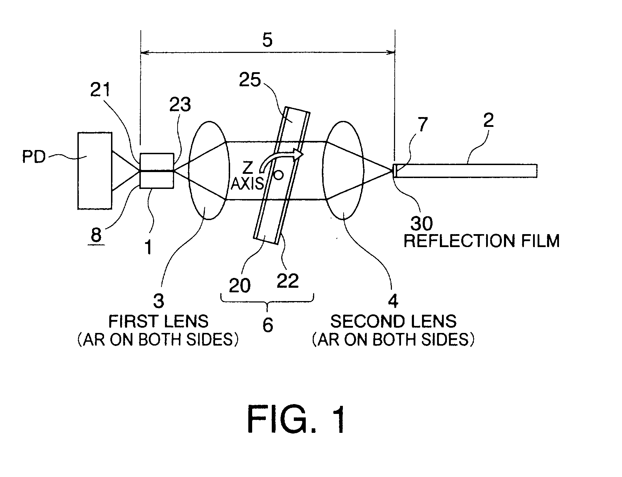

Fig. 1 shows a first embodiment of semiconductive laser module of the present invention.

In this embodiment, a cavity 5 is configured between a reflective film 21 formed on a rear end face 8 of a semiconductive laser device 1 and an input end face 7 (exposed face) of an optical fiber 2 or a low-reflection film 30 formed on the input end face 7.

The semiconductive laser module has a photo diode (PD) 40 for monitoring, the semiconductive laser device 1, a first lens (collimator) 3 for collimated beam from the semiconductive laser device 1, an optical filter (BPF) 6 for transmitting light of wavelength simply within a predetermined range, a second lens (focusing lens) 4 for focusing collimated light from the collimator 3, and the optical fiber 2 for transmitting light focused by the focusing lens 4, arrayed in serial in this sequence.

The semiconductive laser device 1 has on the rear end face 8 thereof the reflection film (HR film) 21 as a coating with a reflectivity as high as 90% or near, and on a front end face 10 thereof a low-reflection film (AR film) 23 as a coating with a low reflectivity.

The reflectivity of the AR film 23 is set to a low value of, for example, 5% or less, and preferably 1% or less, or more preferably 0.1% or less. The HR film 21 of the semiconductive laser device 1 is optimally designed in accordance with a light receiving condition of the PD 40. It however is preferable to provide countermeasures against return light, such as setting a light receiving surface of the PD 40 in oblique position, not to make a cavity between the HR film 21 and the PD 40.

The first lens 3, as well as the second lens 4, has an AR film as a coating thereon with a reflectivity of 0.5% or less . These lenses may each preferably be one of aspherical lens, ball lens, reflectivity distributed lens, flat convex lens, and the like.

The optical fiber 2 includes a PMF in addition to a single mode optical fiber (SMF). In the case where the PMF is employed in part or entirety of the optical fiber 2, polarization holding axes (slow axis, fast axis ) of the PMF may be set in the direction of a polarization plane of laser beam, to allow the laser beam to be transmitted, as it is linearly polarized, or may be set at a predetermined angle, for example at 45 degrees, relative to the direction of the polarization plane, for effecting a depolarization to reduce the DOP of laser beam.

The input end face 7 of the optical fiber 2 is formed as a reflection end face with a coated low-reflection film 30 having, to the laser beam, a reflectivity within a range approximately under 5% and above approx. 0.5% over a wavelength range of ±5 nm or more about a center thereof to be, for example, a light emission wavelength or lasing wavelength of the laser beam.

In the case where the reflectivity at the input end face 7 of the optical fiber 2 is set near 4%, the input end face 7 of the optical fiber 2 may not be provided with the low-reflection film 30, but may have a polished surface or cut face thereof exposed to make use of Fresnel reflection at the exposed face.

Like this, by setting the reflectivity at the optical fiber 2 end of the cavity 5 to a value as low as 5% or less, above approx. 0.5%, the optical fiber 2 is enabled to have high-output light input thereto, allowing a lasing at the cavity 5.

The PD 40 monitors output light behind the semiconductive laser device 1.

Output of the semiconductive laser module is automatically controlled so that the optical output to be detected by the PD 40 remains constant.

In Fig. 1, the optical filter 6 is configured with a substrate 20, such as made of BK7 or quartz, an optical filter film 25 formed on the rear surface of the substrate made of a dielectric multi-layered filter transmitting a desired wavelength of light, and an AR film 22 formed on the front surface. The AR film 22 is designed so as to have an as better transmittance as possible.

The optical filter 6 is inclined to be disposed, at a predetermined inclination angle (for example, 1° ∼ 5°) relative to the optical axis of light to be propagated between the first lens 3 and the second lens 4.

Though the optical filter 6 may be disposed anywhere in the cavity 5, it is preferable for the filter to dispose between the first lens 3 as a collimator and the second lens 4 as a focusing lens, where the input angle to the optical filter 6 is constant at any point on a section of the beam.

It is preferable to make, on the substrate 20 of the optical filter 6, the surface for formation of the optical filter film 25 and that of the AR film 22 (wedge-formed), not to have an etalon formed between the optical filter film 25 and the AR film 22.

Respective films in the present embodiment, such as optical filter film 25 to be first to come, HR film 21, and AR film 23, may be formed with a predetermined number of laminated cavities made for example of Ta₂O₅/SiO₂, TiO₂/SiO₂, or Al₂O₃/SiO₂, allowing associated items such as the number of laminations to be designed for a suitable setting, such as of reflection bandwidth or transmission bandwidth, reflectivity or transmittance, or spectral configuration.

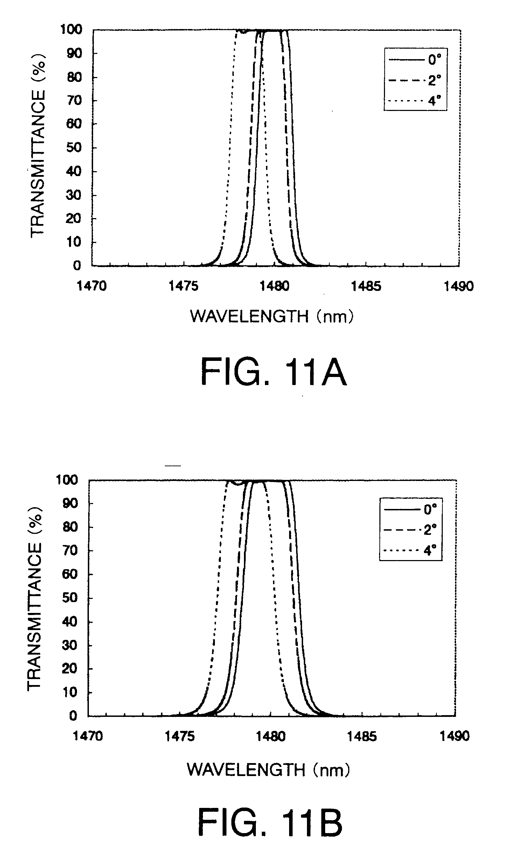

As shown in Fig. 11A and Fig. 11B, the optical filter film 25 has a substantially rectangular transmittance spectrum. In the case of Fig. 11A, the transmission wavelength bandwidth is 2 nm at half width half maximum. In the case of Fig. 11B, the transmission wavelength bandwidth is 3 nm at half width half maximum. In Fig. 11A and Fig. 11B, solid lines, broken lines, and dotted lines represent transmittance spectra when the inclination angle of the optical filter 6 is changed to 0° , 2° , and 4° , respectively. It is shown that, by such changes in inclination angle of the optical filter 6, the transmission spectrum has changed center wavelengths.

By use of the optical filter film 25 having such a substantially rectangular transmittance spectrum configuration, the spectrum of light to be fed back to the semiconductive laser device 1 is controlled, whereby a multi-mode lasing in a laser beam outputted from the semiconductive laser device 1 is facilitated.

By setting the optical intensity of respective one of the longitudinal modes so as not to exceed an SBS occurrence threshold value, it is then allowed to suppress the occurrence of SBS due to the longitudinal mode. Since a plurality of longitudinal modes are allowed to have high optical intensities distributed thereamong, the optical output as a whole can be high.

Because a plurality of longitudinal modes high of level can be implemented, it is possible to render the coherent length of light short. Therefore, in use of depolarizer as a PMF, it is facilitated to reduce the DOP, allowing for the PMF to have a short length, for example, 10nm or under (conventional configuration needs a little less than 30 nm.).

It is significantly difficult for the reflection type optical filter to realize a substantially rectangular spectrum well defined as in Fig. 11A and Fig. 11B, and therefore it is preferable to employ a transmission type optical filter like the embodiment.

Employment of the optical filter 6 allows utilization of the fact that, by rendering larger the inclination angle relative to the optical axis of emitted light from the semiconductive laser device 1, the lasing wavelength is shifted toward the shorter wavelength side, as shown in Fig. 11A and Fig. 11B, so that the lasing wavelength can be tuned by adjustment of the inclination angle.

In this case, the inclination may be in any direction from the position in which light is normally input to the optical filter 6, whereas the polarization dependency disappears if the inclination is parallel or perpendicular to the direction of the polarization plane, so that the occurrence of PDL (polarization dependent loss) can be suppressed even with an inclination at several ten degrees.

As a method of tuning the lasing wavelength, else than described, there is also an example in which the thickness of each layer of the optical filter film 25 is controlled so that the transmittance spectrum of light is varied in dependence on the position of transmission of the light at the optical filter film 25 in the optical filter 6, and then the optical filter 6 is moved substantially in the perpendicular direction to the optical axis, to change the position at which light is input to the optical filter 6, thereby changing the transmission position of light in the optical filter film 25, thus tuning the lasing wavelength.

The optical filter 6 is mounted on a thermomodule (for example, a Peltier module, not shown) on which the semiconductive laser device 1 is mounted, so that, by the placement together with the semiconductive laser device 1 under temperature control by the Peltier element, the wavelength shift as well as disorder of waveform is eliminated, having a stable characteristic. The optical filter 6 may be mounted on a module else than the thermomodule on which the semiconductive laser device 1 mounted.

In this semiconductive laser module, emitted light from the front end face 10 of the semiconductive laser device 1 is collimated by the first lens 3, has wavelengths selected by the optical filter 6, is focused by the second lens 4, and is reflected in part by the input end face 7 of the optical fiber 2, to be optically fed back to the semiconductive laser device 1, via a reverse route. The remainder of light is input to the optical fiber 2, where it is transmitted.

By the optical feedback and reciprocation in the cavity 5, there is caused a lasing in the semiconductive laser device 1, which outputs a laser beam. Mere desired wavelengths of light are selected by the optical filter 6, to be optically fed back to the semiconductive laser device 1, whereby the laser beam has a stabilized wavelength characteristics. The laser beam is transmitted by the optical fiber 2, to be used for a desired purpose.

In the semiconductive laser module according to this embodiment, the cavity length can be set short (for example, 20 nm and under), allowing for prevention of a deterioration that the noise characteristic might have suffered in a predetermined frequency bandwidth due to a longer cavity.

By employment of the optical filter 6, the spectrum width of light can be compressed narrow, allowing for an enhanced optical output and for a good wavelength stability.

Further, the transmission spectrum of the optical filter 6 is set to a predetermined configuration, whereby output light from the semiconductive laser device 1 is allowed to be multi-mode, so that the occurrence of SBS can be prevented, with a maintained high optical output. The multi-mode is advantageous also for DOP reduction.

Like this, the semiconductive laser module according to this embodiment is essentially adapted to have necessary characteristics as a pumping light source for Raman amplifiers.

### Second embodiment of semiconductive laser module

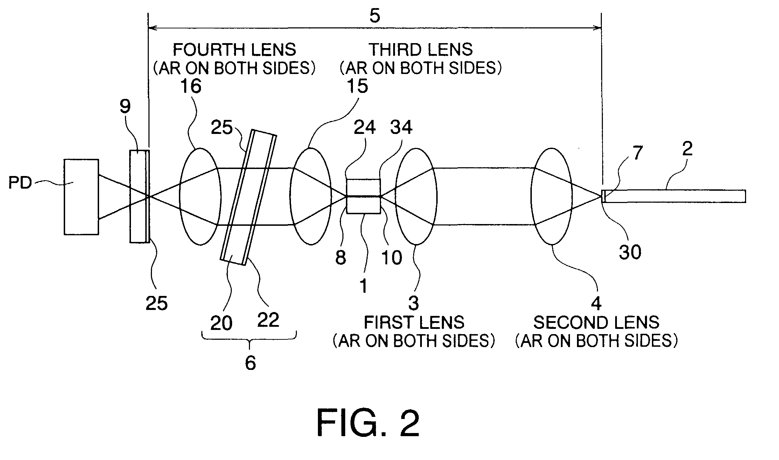

Fig. 2 shows a second embodiment of semiconductive laser module of the present invention.

In the following embodiments, like configuration to a preceding embodiment is designated by like reference character, and associated description may be omitted.

In this embodiment, a cavity 5 is configured between a reflection film 26 of a reflective parts 9 and an input end face 7 (exposed face) of an optical fiber 2 or a low-reflection film 30 formed on the input end face 7.

The semiconductive laser module, as a configuration with an optical filter 6 disposed behind a semiconductive laser device 1, has a PD 40, the reflective parts 9, a fourth lens (collimator) 16, the optical filter 6, a third lens (focusing lens) 15, the semiconductive laser device 1, a first lens 3, a second lens 4, and the optical fiber 2, arrayed in serial in this sequence.

The semiconductive laser device 1 has on a front end face 10 thereof an AR film 34 and on a rear end face 8 thereof an AR film 24, each as a coating thereon. The reflectivity of the AR films 24, 34 is, for example, 5% or less, and may preferably be 1% or less, or more preferably 0.1% or less.

The third lens 15 and the fourth lens 16, as well as the first lens 3 and the second lens 4, are coated at their font and rear surfaces by AR films, whose reflectivity is ,for example, 0.5% or less. These lenses also may each preferably be one of aspherical lens, ball lens, reflectivity distributed lens, flat convex lens, and the like, to be selected as necessary.

The optical filter 6 is configured to be the same as in the first embodiment, except for the disposition between the third lens 15 and the fourth lens 16, and may preferably be temperature-controlled on a thermomodule like the first embodiment.

In this semiconductive laser module, emitted light from the rear end face 8 of the semiconductive laser device 1 is collimated by the third lens 15, has wavelengths selected by the optical filter 6, is focused by the fourth lens 16, and is optically fed back by a reflection film 26. Emitted light from the front end face 10 of the semiconductive laser device 1 is transmitted via the first lens and the fourth lens, and optically fed back in part at the input end face 7 of the optical fiber 2 to the semiconductive laser device 1, while the remainder is input to the optical fiber 2, where it is transmitted.

By the optical feedback and reciprocation in the cavity 5, there is caused a lasing in the semiconductive laser device 1, which outputs a laser beam. Mere desired wavelengths of light are selected by the optical filter 6, to be optically fed back to the semiconductive laser device 1, whereby the laser beam has a stabilized wavelength characteristics. The laser beam emitted from the front end face 10 of the semiconductive laser device 1 is transmitted by the optical fiber 2, to be used for a desired purpose.

Also in the semiconductive laser module according to this embodiment, there can be achieved similar effects to the first embodiment.

### Third embodiment of semiconductive laser module

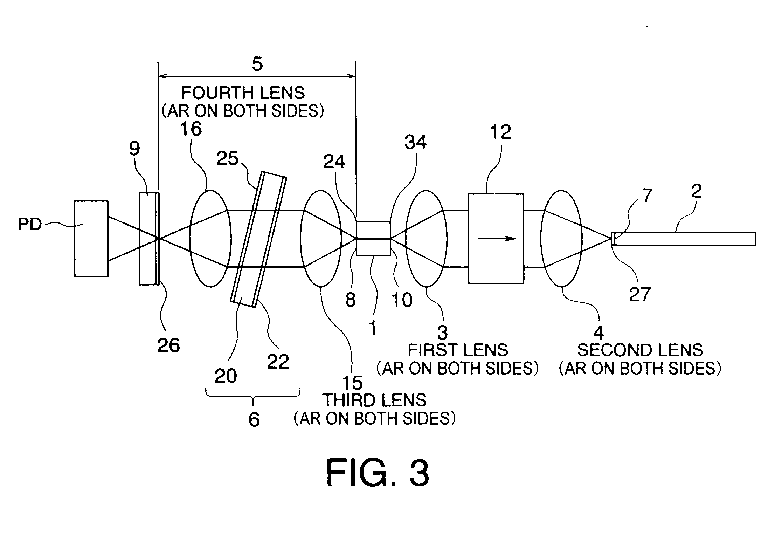

Fig. 3 shows a third embodiment of semiconductive laser module of the present invention.

In this embodiment, a cavity 5 is configured between a reflection film 26 of a reflective parts 9 and an AR film 34 formed on a front end face 10 of a semiconductive laser device 1.

The semiconductive laser module according to this embodiment is a little modified in configuration from the semiconductive laser module according to the second embodiment. That is, the AR film 34 formed on the front end face 10 of the semiconductive laser device 1 is set in reflectivity to 2% - 5% or near, and an AR film 27, whose reflectivity is, for example, 1% or less, is formed an input end face of an optical fiber 2. The cavity 5 is thereby formed as described between the reflection coating 26 of the reflective parts 9 and the AR film 34 formed on the front end face of the semiconductive laser device 1. As an optical isolator 12 is allowed to be interposed between first and second lenses 3, 4 disposed at the optical fiber 2 side of the cavity 5, it is unnecessary to cut the optical fiber 2, on the way, for insertion of the optical isolator 12.

A package provided for incorporating the semiconductive laser device 1, first lens 3, and second lens 4 can incorporate the optical isolator 12 as well, thus allowing for an entirety of the semiconductive laser module to be compact. Possible employment of a polarization dependent optical isolator allows an inexpensive provision of semiconductive laser module.

In addition, there can be achieved similar effects to the semiconductive laser modules of the first, and the second embodiment.

### Fourth embodiment of semiconductive laser module

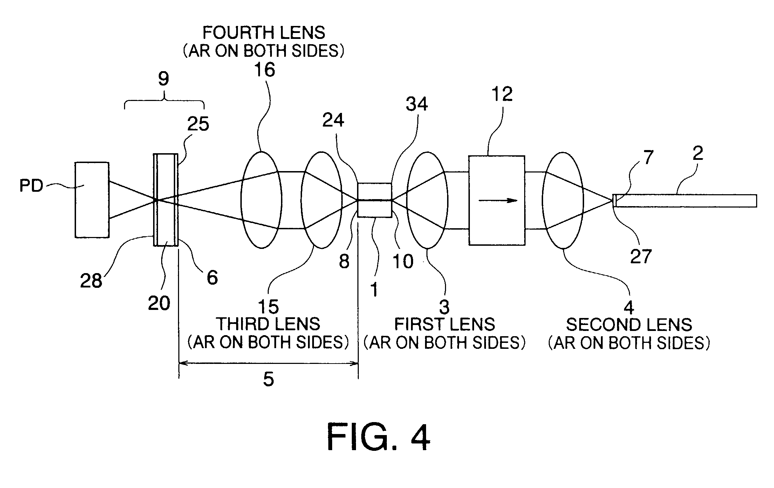

Fig. 4 shows a fourth embodiment of semiconductive laser module of the present invention.

The semiconductive laser module according to this embodiment is a little modified in configuration from the semiconductive laser module according to the third embodiment. That is, the optical filter 6 and the reflective parts 9 in the third embodiment are integrated with each other. In other words, there is provided a reflective parts 9 (optical filter 6) in which a substrate 20 has at the rear face side a reflection coating 28 formed thereon with a reflectivity over 90% for example and at the front face side an optical filter film 25 formed thereon. As the reflection coating 28 and the optical filter film 25 are set non-parallel, the formation of an etalon is prevented therebetween.

In addition, there can be achieved similar effects to the semiconductive laser module of the third embodiment.

### Fifth embodiment of semiconductive laser module

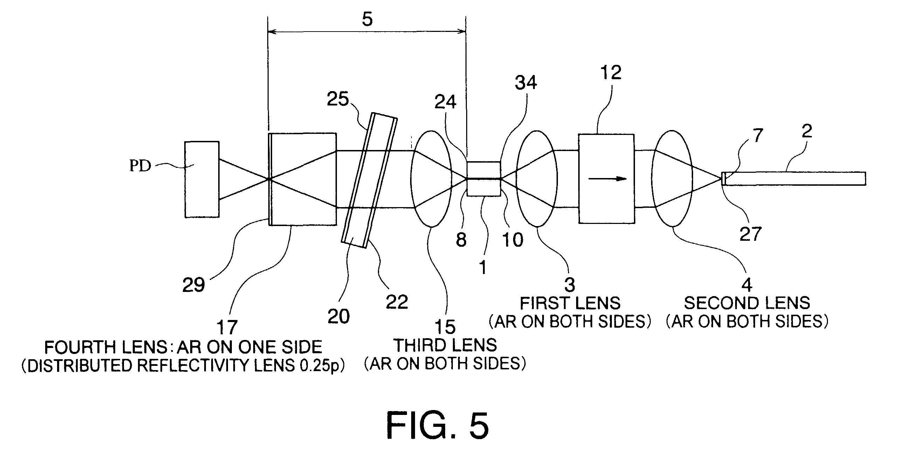

Fig. 5 shows a fifth embodiment of semiconductive laser module of the present invention.

The semiconductive laser module according to this embodiment is a little modified in configuration from the semiconductive laser module according to the third embodiment. That is, there is employed a reflectivity distributed lens 17 and a reflection coating 29 in place of fourth lens 16 and reflective parts 9 in the third embodiment.

By such employment of the reflectivity distributed lens 17, it is possible to aim a compact semiconductive laser module.

In addition, there can be achieved similar effects to the semiconductive laser module of the third embodiment.

### Sixth embodiment of semiconductive laser module

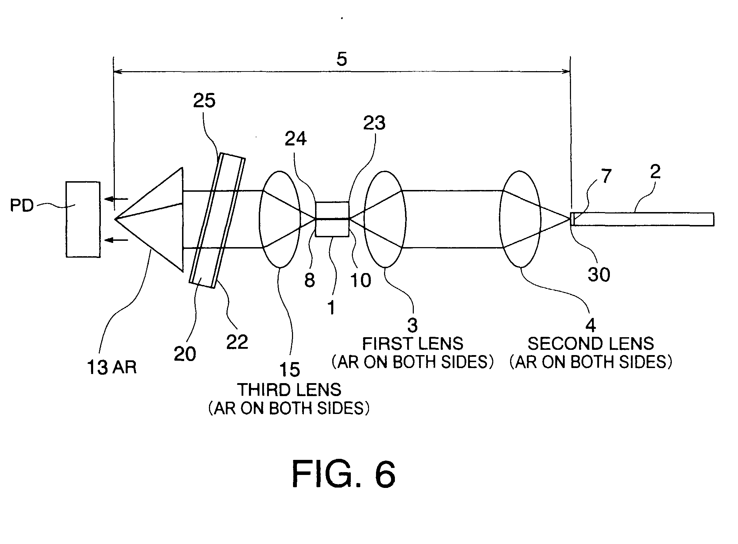

Fig. 6 shows a sixth embodiment of semiconductive laser module of the present invention.

The semiconductive laser module according to this embodiment is a little modified in configuration from the semiconductive laser module according to the second embodiment. That is, there is employed a corner cube 13 in place of the combination of fourth lens 16 and reflective parts 9 in the second embodiment.

Such employment is preferable in that the corner cube 13 can be centered with ease, and the deterioration of optical coupling efficiency is little even in occurrences of positional deviation of the corner cube 13.

In addition, there can be achieved similar effects to the semiconductive laser module of the second embodiment.

### Seventh embodiment of semiconductive laser module

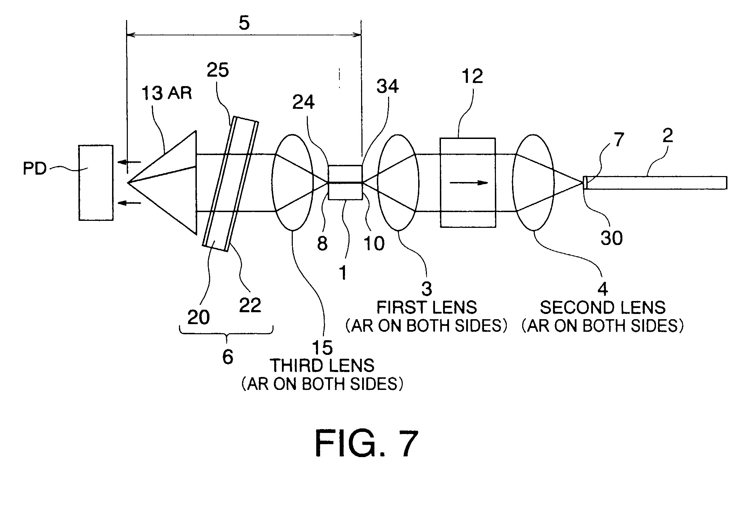

Fig. 7 shows a seventh embodiment of semiconductive laser module of the present invention.

The semiconductive laser module according to this embodiment is a little modified in configuration from the semiconductive laser module according to the third embodiment. That is, there is employed a corner cube 13 in place of fourth lens 16 and reflective parts 9 in the third embodiment.

By such employment of the corner cube 13, there can be achieved similar effects to the sixth embodiment.

In addition, there can be achieved similar effects to the semiconductive laser module of the third embodiment.

### Eighth embodiment of semiconductive laser module

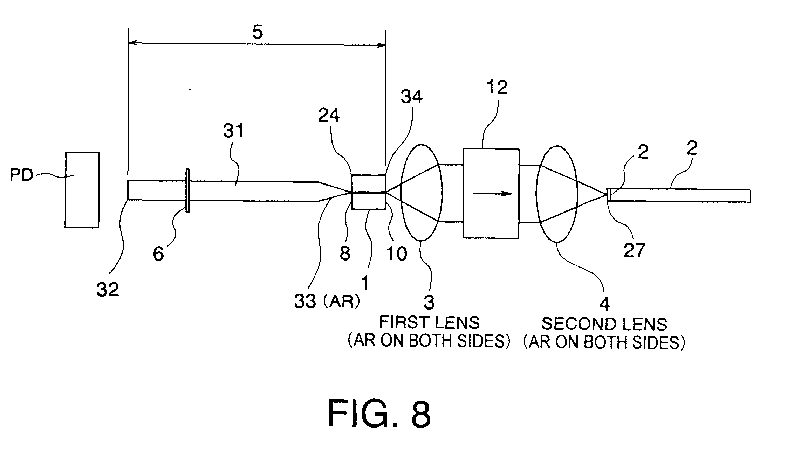

Fig. 8 shows an eighth embodiment of semiconductive laser module of the present invention.

In this embodiment, a cavity 5 is configured between a reflection coating 32 of a lensed fiber 31 and an AR film 34 formed on a front end face 10 of a semiconductive laser device 1.

The semiconductive laser module, as a configuration with an optical filter 6 disposed behind the semiconductive laser device 1, has a PD 40, the lensed fiber 31 provided with the optical filter 6 in the way, the semiconductive laser device 1, a first lens 3, an optical isolator 12, a second lens 4, and an optical fiber 2, arrayed in serial in this sequence.

The semiconductive laser device 1 has on the front end face 10 the AR film 34 as a coating thereon. On a rear end face 8 thereof is formed an AR film 24. The reflectivity of the AR films 34 on the front end face is set, for example, within 2% - 5%. The reflectivity of the AR film 24 on the rear end face is, for example, 1% or less, and may preferably be 0.1% or less.

The lensed fiber 31 is processed in a lens configuration at a front end thereof to have an AR film 33 formed on a surface of this end, and is cut at a rear end thereof, perpendicularly to the longitudinal direction of the lensed fiber, to have the AR film 32 formed thereon. The lens configuration at the front end may be a selected one, such as a wedge configuration or a ball-pointed configuration, to be suitable in accordance with a sectional configuration of emitted light from the semiconductive laser device 1. The reflectivity of the AR film 33 is, for example, 1% or less, while the reflectivity of the AR film 32 is 90% or more.

The lensed fiber 31 has a cut part in the longitudinal way, where the optical filter 6 is inserted.

The insertion of the optical filter 6 is set in a perpendicular direction to an optical axis of the lensed fiber in this embodiment, but may preferably be set oblique.

In this semiconductive laser module, emitted light from the rear end face 8 of the semiconductive laser device 1 is transmitted in the lensed fiber 31, where it has wavelengths selected by the optical filter 6, to be optically fed back in part by the reflection coating 32 to the semiconductive laser device 1, while the remainder of light is received by the PD 40.

On the other hand, emitted light from the front end face 10 of the semiconductive laser device 1 is collimated by the first lens 3, focused by the second lens 4, and input to the optical fiber 2, where it is transmitted.

By the optical feedback and reciprocation in the cavity 5, there is caused a lasing in the semiconductive laser device 1, which outputs a laser beam. Mere desired wavelengths of light are selected by the optical filter 6, to be optically fed back to the semiconductive laser device 1, whereby the laser beam has a stabilized wavelength characteristics. The laser beam emitted from the front end face 10 of the semiconductive laser device 1 is transmitted by the optical fiber 2, to be used for a desired purpose.

Also in the semiconductive laser module according to this embodiment, there can be achieved similar effects to the semiconductive laser module according to the first embodiment, while it additionally is possible to interpose an optical isolator 12 between the first lens 3 and the second lens 4.

It is noted that, also in any embodiment else than the present embodiment, such an optical coupling system as a combination of first lens 3 and second lens 4 or of third lens 15 and fourth lens 16 may be suitably substituted by the combination of an optical fiber processed in a lens configuration at an end thereof and an optical filter 6 inserted in the way thereof.

### First embodiment of Raman amplifier

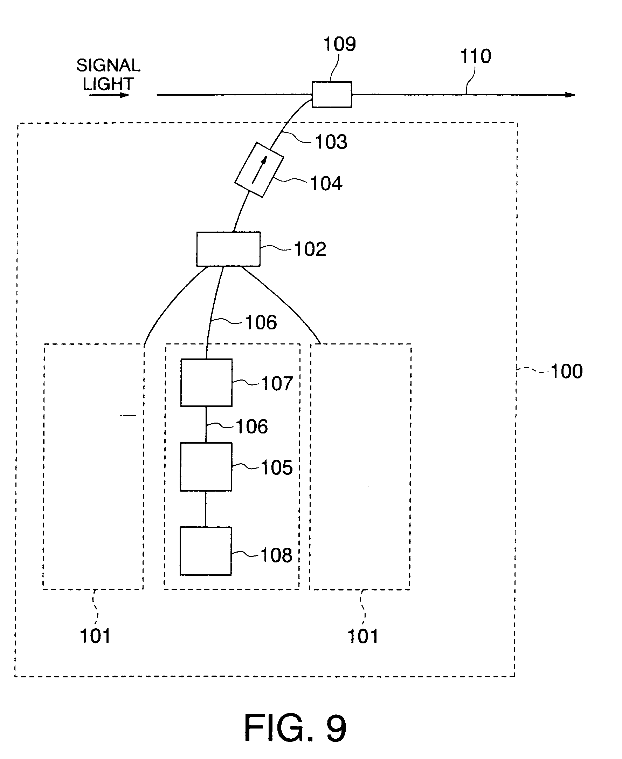

Fig. 9 shows an embodiment of Raman amplifier 100 in which the semiconductive laser module described in any of the foregoing embodiments is used as a pumping light source module. In Fig. 9, the Raman amplifier 100 is configured as a forward pumping type optical amplifier having a plurality of laser units 101 for outputting different wavelengths of light, a WDM coupler 102 for performing a wavelength combination of output light from the laser units 101, an optical fiber 103 for transmitting the wavelength-combined light, and a polarization dependent type optical isolator 104 disposed in the optical fiber 103.

Each laser unit 101 has a semiconductive laser module 105 described in any of the foregoing embodiments, an optical fiber 106 for transmitting output light from the semiconductive laser module 105, a depolarizer 107 as a PMF inserted in the optical fiber 106, and a controller 108.

The semiconductive laser module 105 of each laser unit 101 is adapted to output a laser beam of a particular wavelength different from other laser units 101 in accordance with operational control of the semiconductive laser device by the controller 108, for example, control on an injection current or Peltier module temperature.

The depolarizer 107 may for example be a PMF provided at least one part of the optical fiber 106, with a proper axis inclined at 45 degrees relative to a polarization plane of the laser beam outputted from the semiconductive laser module 105. By such an arrangement, it is allowed for the laser beam outputted from the semiconductive laser module 105 to be reduced in DOP, not to be polarized.

The optical isolator 104 passes the laser beam outputted from the semiconductive laser module 105, while cutting return light to the semiconductive laser module 105. It however is unnecessary to use the in-line optical isolator 104 in the case the semiconductive laser module 105 has an incorporated optical isolator.

In the Raman amplifier 100 with such a configuration, laser beams outputted from the semiconductive laser modules 105 are reduced in DOP by the depolarizers 107 in the respective laser units 101, and then combined between different wavelengths of light by the WDM coupler 102, to be transmitted through the optical fiber 103, via the optical isolator 104, to a WDM coupler 109, whereby the transmitted light is input to an optical fiber 110, where signal light is transmitted.

In the optical fiber 110, the signal light being transmitted is Raman amplified by the input laser light (pumping light).

In the Raman amplifier 100 according to this embodiment, by use of laser units 101 and semiconductive laser modules 105 according to any of the foregoing embodiments, it is allowed to have a high Raman gain, with a suppressed SBS in the optical fiber 110. The PMF, which is necessary as a depolarizer 107 for DOP reduction, can be short, allowing for the laser units 101 and the Raman amplifier 100 to be small-sized. The use of an optical filter reflecting predetermined wavelengths of light allows the Raman gain to be satisfactory in wavelength stability.

### Second embodiment of Raman amplifier

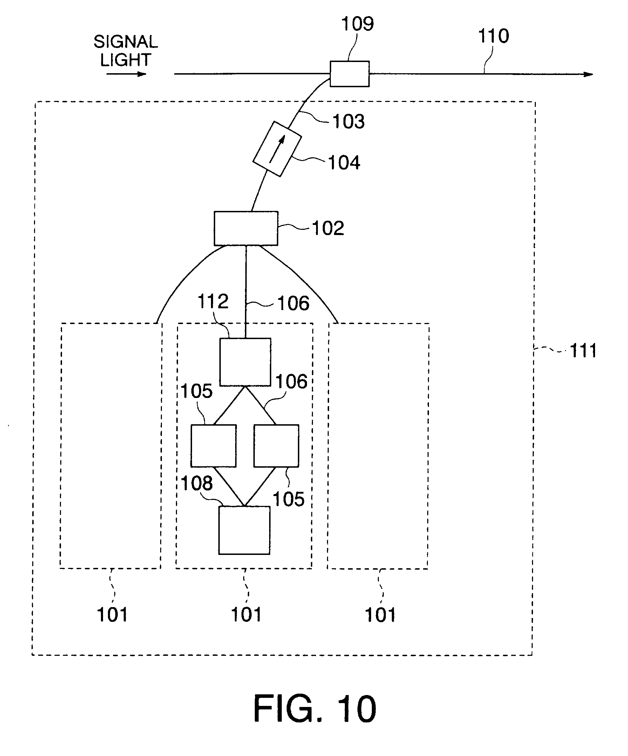

Fig. 10 shows another embodiment of Raman amplifier in which the before-mentioned semiconductive laser module is used as a pumping light source module. In Fig. 10, the Raman amplifier 111 is configured as a forward pumping type optical amplifier having a plurality of laser units 101 for outputting different wavelengths of light, a WDM coupler 102 for performing a wavelength combination of output light from the laser units 101, an optical fiber 103 for transmitting the wavelength-combined light, and a polarization dependent type optical isolator 104 disposed in the optical fiber 103.

Each laser unit 101 has two semiconductive laser modules 105 described in any of the foregoing embodiments, optical fibers 106 for respectively transmitting laser beams outputted from the semiconductive laser modules 105, a PBC (polarization beam combiner) 112 for performing a polarization combination of the laser beams, an optical fiber 106 for transmitting a polarization-combined beam, and a controller 108 constituting a control means in the present invention.

The plural semiconductive laser modules 105 of each laser unit 101 is adapted to output laser beams with different wavelengths in accordance with operational control of the semiconductive laser device by the controller 108, for example, control on an injection current or Peltier module temperature.

The optical isolator 104 passes the laser beams outputted from the semiconductive laser modules 105, while cutting return light to the semiconductive laser modules 105. It however is unnecessary to use the in-line optical isolator 104 in the case the semiconductive laser modules 105 have their incorporated optical isolators.

In the Raman amplifier 111 with such a configuration, laser beams outputted from the semiconductive laser modules 105 enter the PBC's 112, where they are combined between polarized light identical in wavelength and different in polarization plane, with reduced degrees of polarization, before resultant light enter the WDM coupler 102, where they are wavelength-combined, to be transmitted through the optical fiber 103, via the optical isolator 104, to a WDM coupler 109, whereby the transmitted light is input to an optical fiber 110, where signal light is transmitted.

In the optical fiber 110, the signal light being transmitted is Raman amplified by the input laser light (pumping light).

In the Raman amplifier 111, by use of laser units 101 and semiconductive laser modules 105 according to any of the foregoing embodiments, it is allowed to have a high Raman gain, with a suppressed SBS in the optical fiber 110. The use of an optical filter reflecting predetermined wavelengths of light allows the Raman gain to be satisfactory in wavelength stability.

It is noted that the present invention is not limited to the embodiments described, and there can be various changes and modifications within a scope of the summary of the invention.

### Third embodiment of Raman amplifier

Although, in the foregoing embodiments, description is made of Raman amplifiers of the forward pumping system to which the present invention is particularly preferably applicable, the present invention is not limited to those, and may preferably be applied to the backward pumping system or bi-directional pumping system.

### Effects of the present invention

According to the present invention, a pumping light source oriented module, a laser unit, and a Raman amplifier using either of them have such effects as follow:
1. By use of an optical filter, a resonator as a cavity is allowed to have a gain residing simply within a transmission wavelength bandwidth of he optical filter, with the cavity's resonant wavelength fixed and stable.
2. With the cavity's resonant wavelength fixed and the intensity of pumping light stable, the Raman gain also is stable, allowing application to the forward pumping as well.
3. In the use of an optical filter having a transmittance spectrum of a substantially rectangular form (a wide wavelength bandwidth), an envelope of the lasing spectrum involves a plurality of longitudinal modes of output light. An entire optical output of the lasing is thus shared among the plurality of longitudinal modes, with a decreased intensity of light per single longitudinal mode. Therefore, the SBS is reduced, with a possible prevention of noise increase.
4. As an envelope of the lasing spectrum involves a plurality of longitudinal modes of a semiconductive laser device, the lased laser beam has a reduced coherent length. It therefore is possible for a necessary length of PMF for depolarization to be shorter in comparison with a conventional pumping light source.
5. The reflectivity of an optical feedback part at the light projecting side can be reduced, so that the intensity of pumping light to be obtained by an optical fiber is enhanced.
6. In the case the optical feedback part is an input end face 7 of the optical fiber, as it is compared with a conventional pumping light source in which a fiber grating (one reflection end face of the cavity) is disposed at a greater distance than the input end face 7 of the optical fiber, the end face to end face distance of the cavity can be short, allowing for the cavity to be compact, with a reduced noise.
7. The inclination angle of the optical filter 6 is adjustable, allowing for the resonant wavelength to be adjusted to some extent.
8. In the use of an optical isolator, there is found little reflection return light, with a stable laser operation.
9. The optical filter can be temperature-controlled on a thermomodule, to have a stable characteristic.
10. Irrespective of driving conditions, there can be achieved a constant resonant wavelength to be maintained, a reduced noise without increase in noise due to Brilloun scattering, and a facilitated depolarization.

## Claims

1. A semiconductive laser module comprising:
a semiconductive laser device;
a cavity formed with at least one light feedback means included;
an optical fiber located at a front side of the cavity; and
wherein an optical filter for transmitting light of wavelength within a predetermined range is disposed in the cavity.

2. A semiconductive laser module comprising:
a semiconductive laser device:
a cavity formed with at least one light feedback means included;
an optical fiber located at a front side of the cavity; and
wherein a collimator and a focusing lens for coupling emitted light from the semiconductive laser device with the optical fiber, an optical filter for transmitting light of wavelength within a predetermined range is disposed in the cavity, and the optical filter is disposed between the collimator and the focusing lens.

3. A semiconductive laser module according to claim I or claim 2 wherein the optical filter has a transmittance spectrum of a substantially rectangular form.

4. A semiconductive laser module according to claim 1 or claim 2 wherein the optical filter has a dielectric multi-layered filter for transmitting a desired wavelength.

5. A semiconductive laser module according to claim 1 or claim 2 wherein the optical filter is disposed oblique to an optical axis.

6. A semiconductive laser module according to claim 1 or claim 2 wherein an optical feedback part provided at the optical fiber side of the cavity has a reflectivity of 5% or under.

7. A semiconductive laser module according to claim 1 or claim 2 wherein the optical filter is temperature-controlled on a thermomodule.

8. A semiconductive laser module according to claim 1 or claim 2 wherein the optical filter is configured for a tuning of transmission wavelength by rotation.

9. A semiconductive laser module according to claim 1 or claim 2 wherein at least one optical feedback means is a reflection coating formed on a front end face or a rear end face of the semiconductive laser device.

10. A semiconductive laser module according to claim 1 or claim 2 wherein at least one optical feedback means is an exposed face of an input end face of the optical fiber or a reflection coating formed on said input end face.

11. A semiconductive laser module according to claim 1 or claim 2 wherein at least one optical feedback means is a reflective parts.

12. A semiconductive laser module according to claim 1 or claim 2 wherein at least one optical feeback means is a corner cube.

13. A semicondutive laser module according to claim 1 or claim 2 wherein an optical isolator is disposed between the cavity and an input end face of the optical fiber.

14. A semiconductive laser module according to claim 1 or claim 2 wherein the optical filter is inserted into a lensed fiber.

15. A semiconductive laser module according to claim 1 or claim 2 wherein a deporalizer for reducing a degree of polarization of a laser beam is disposed.

16. A laser unit comprising a plurality of semiconductive laser modules according to claim 1 or claim 2, and a polarization beam combiner for polarization-combining the light emitted from the plurality of semiconductive laser modules.

17. A Raman amplifier comprising a semiconductive laser module according to claim 1 or claim 2 as a pumping light source.

18. A Raman amplifier comprising a laser unit according to claim 16 as a pumping light source.
